# EUROPEAN PATENT APPLICATION

(11) **EP 4 641 227 A1**
(43) Date of publication of application: **29.10.2025**
(21) Application number: 24172446.7
(22) Date of filing: 25.04.2024
(51) Int. Cl.: G01R 31/34, G01R 31/385

(54) **TRANSPORTABLE TEST ARRANGEMENT**

(71) Applicant: Proventia Oy, 90460 Oulunsalo (FI)
(72) Inventor: Vuokila, Panu, 90460 Oulunsalo (FI); Ruotsalainen, Mikko, 90460 Oulunsalo (FI); Mäkikangas, Ville, 90460 Oulunsalo (FI); Kähkönen, Ville-Veikko, 90460 Oulunsalo (FI); Posio, Hanna, 90460 Oulunsalo (FI); Koskela, Ilkka, 90460 Oulunsalo (FI)
(74) Representative: Kolster Oy Ab

(57) **Abstract**

A transportable test arrangement (100) comprising a transportable container (102) having at least a first internal space (IS1), wherein one side of the first internal space (IS1) is open to form a cavity (C) inside the transportable container (102), and a replaceable test chamber (104) forming a test space (TS) for receiving one or more components to be tested and/or test equipment. The cavity (C) in the transportable container (102) is configured to receive the replaceable test chamber (104) via the open side of the first internal space (IS1) such that the test chamber (104) is substantially inside the container, and wherein the replaceable test chamber (104) is removably coupled with the transportable container (102).

## Description

### Field

Various embodiments described herein relate to transportable test arrangements, especially for testing electric components of cars, such as battery components and electric motors, for example.

### Background

Manufacturers of electric car components such as engine or battery manufacturers, and/or car manufacturers, require testing facilities for testing the components. The testing may involve testing operations and capabilities of the components under various scenarios. Some of the testing operations may expose the components to explosions. For example, the components may be heavily stressed in the testing that may lead exploding of the component. The explosion risk sets special requirements to the testing facilities. The explosion may damage the test facilities, or even destroy it, that may cause significant cost and delays in the testing. The invention is aimed to alleviate these issues.

### Brief description of the invention

The invention is defined by the subject-matter of the independent claim. Embodiments are defined in the dependent claims.

One or more examples of implementations are set forth in more detail in the accompanying drawings and the description of embodiments.

### List of drawings

In the following, the invention will be described in greater detail with reference to the embodiments and the accompanying drawings, in which
Figure 1A, 1B, 3B, 5, 6 and 7 illustrate a transportable test arrangement according to embodiments of the invention;
Figure 2 and 3A illustrates a container of the transportable test arrangement according to embodiments of the invention; and
Figure 4 illustrates a replaceable test chamber of the transportable test arrangement according to an embodiment of the invention.

### Description of embodiments

The following embodiments are exemplifying. Although the specification may refer to "an", "one", or "some" embodiment(s) in several locations of the text, this does not necessarily mean that each reference is made to the same embodiment(s), or that a particular feature only applies to a single embodiment. Single features of different embodiments may also be combined to provide other embodiments.

In the case of the explosion in the component testing, the damaged test chamber shall be quickly and easily repaired/replaced to continue the testing operations. Conventionally, testing of electric car components, such as batteries and electric motors, is carried out in special-purpose testing facilities within a manufacturing facility, for example. The testing facilities may be built as an integral part of other facilities such as manufacturing facilities that lacks flexibility. This causes many challenges especially in the case of the explosion if the test facility is damaged. Furthermore, the explosion in the manufacturing facilities may expose manufacturing facilities and operators working therein to damages.

The invention is aimed to alleviate the known issues of the conventional testing solution of the components.

According to an aspect of the invention, there is provided a transportable test arrangement comprising a transportable container having at least a first internal space, wherein one side of the first internal space is open to form a cavity inside the transportable container, and a replaceable test chamber forming a test space for receiving one or more components to be tested and/or test equipment, wherein the cavity in the transportable container is configured to receive the replaceable test chamber via the open side of the first internal space such that the test chamber is substantially inside the container, and wherein the replaceable test chamber is removably coupled with the transportable container.

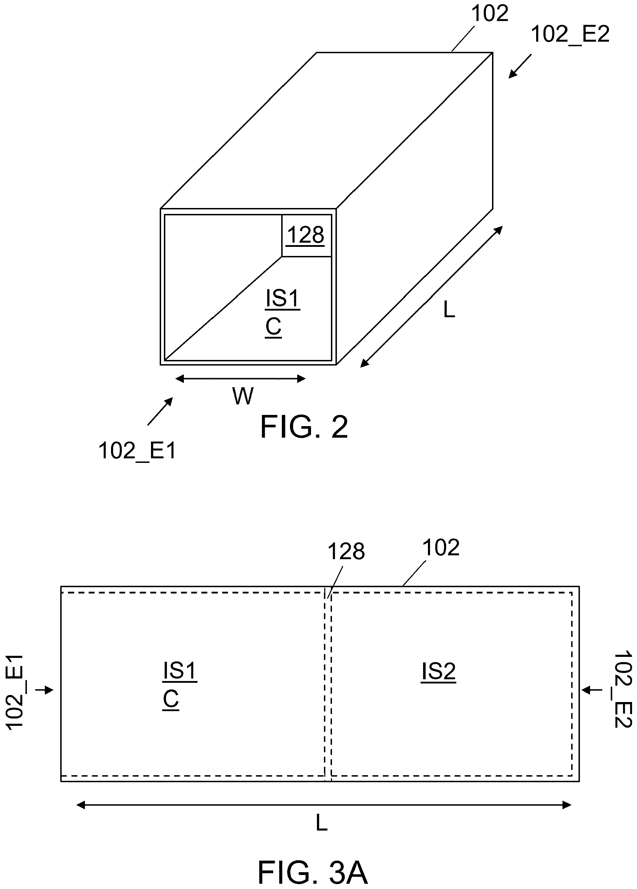

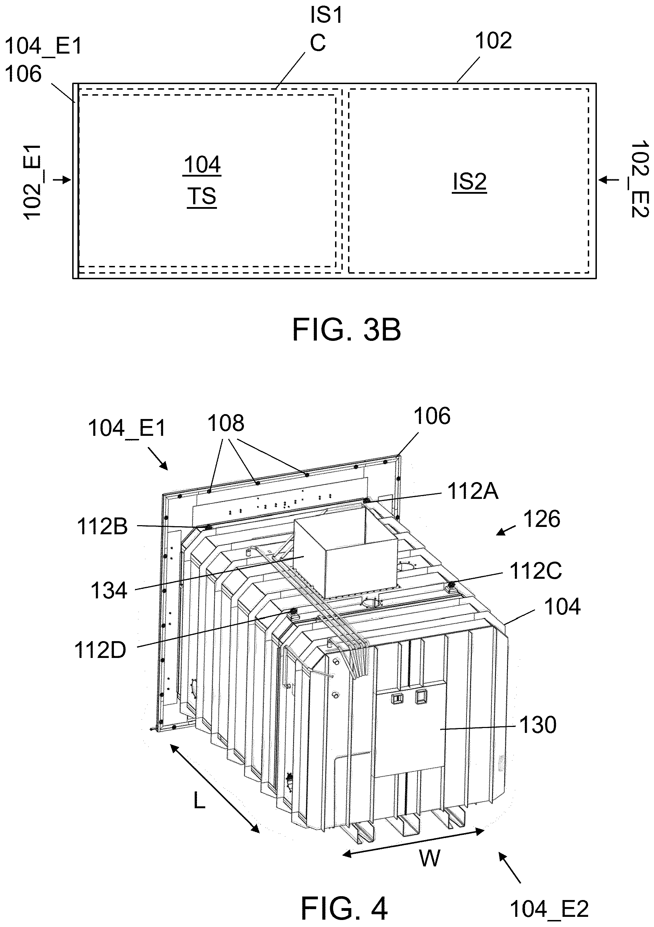

Figures 2 and 4 illustrate a length direction L of the test chamber 104 and the container 102 as well as a width direction W. So, the length and width direction are same for the container and the test chamber. The length direction may refer to a longitudinal direction of the container and/or the test chamber.

The transportable container may be any kind of container that forms an inner space. The container may be a commercial freight container, for example. Such container provides several advantages. The test chamber is easy to build, modify, transport, replace, and remove. Furthermore, the needed investments are low. One particular advantage related to the ability to provide the test chamber outside the fixed buildings is an outcome in case of the explosion or a fire. As described above, the electric vehicle components under test may occasionally ignite fire or even explode during the testing. Normally in the case of the explosion or fire, the container may be damaged that can be overcome by replacing the container. The container comprises many kinds of equipment and structures that are needed in the testing operation and therefore, cost of the whole container may be remarkable.

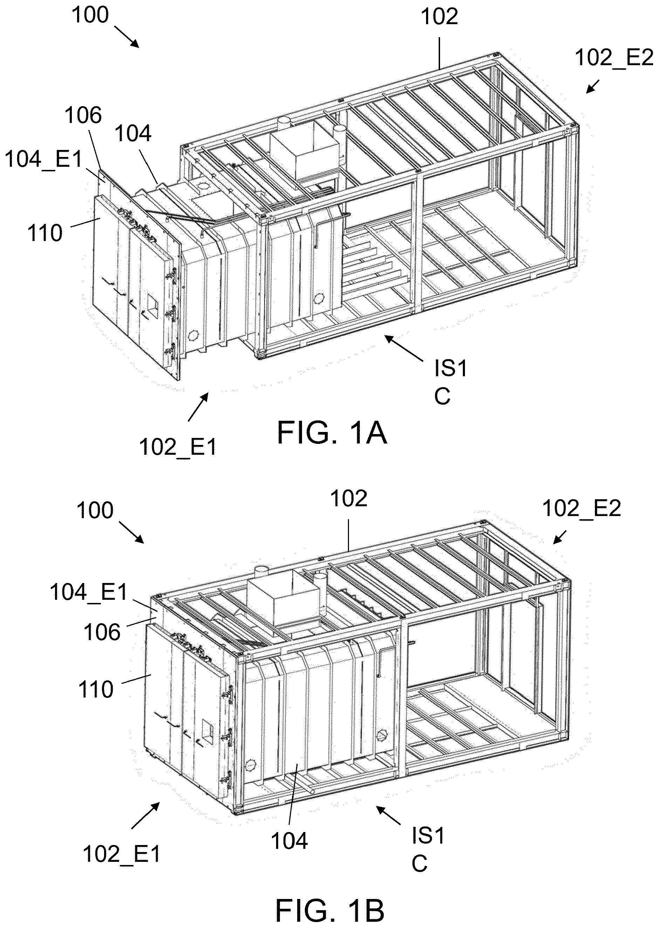

Referring to Figures 1A and 1B, in the invention, the test arrangement further comprises a separate replaceable test chamber 104 for receiving the component(s) to be tested and/or at least part of the test equipment, and wherein the replaceable test chamber is configured to be removably coupled with the container 102. The container is presented without side and end walls and a roof in Figures 1A and 1B such that the test chamber inside the container can be seen. Normally only one side of the container may be open as illustrated in Figure 2. The term "replaceable" means that the test chamber can be changed, for example, if it is damaged in the explosion. The test chamber comprises the test space that is a room in which the component(s) to be tested and/or the test equipment are placed. Hence, the test space may refer to an inner space of the test chamber. The test space may be dimensioned such that person(s) can move inside it, for example. The test space TS is illustrated in Figure 3B that illustrates an installed state of the test chamber 104, in other words, the state in which the test chamber 104 is inside the cavity C. The test chamber is configured to withstand the explosion of the component such that the damage is limited inside the chamber, in other words, the damage is limited inside the test space. The test chamber may be made of stainless steel and is dimensioned to withstand the possible explosion of the components to be tested. The test equipment may refer to a climate chamber or equivalent, for example. The component to be tested may be placed inside the climate chamber during the test. The climate chamber may not be capable of withstanding the explosion like the test chamber (test space) to which the climate chamber may be placed. The test equipment may also refer to another part like a dynamometer and/or a fixture for fixing the component to be tested in testing, for example.

Referring now to Figure 2 and 3A, the container 102 comprises the first internal space IS1 that is open such that the space forms the cavity C extending inside the container 102. It is important to realize that the first internal space IS1 and the cavity C may mean the same space since the first internal space IS1 forms the cavity C when its one side is open. For example, one side of the container may be removed to form the open structure that have internal partly open space inside the container. The cavity is configured to receive the replaceable test chamber such that the test chamber is, at least mainly, inside the cavity in the installed state as illustrated in Figure 1A. Hence, in the case of the explosion or fire, there is no need to replace the whole container, only the possibly damaged test chamber. Replacing the test chamber only is much faster and cheaper that replacing the whole container that may comprise a lot of test equipment and test control equipment. As said, the container may comprise a basic infra needed for the component testing that may be complicated and expensive, and the test chamber is just a space in which the testing takes place that is removably connected with the testing infra arranged in the container. Therefore, the test chamber may comprise as less as possible expensive testing infra (test equipment and its control systems). Providing only the new test chamber instead of the whole container is also logistically easier due to the smaller size of the test chamber.

Hence, the modular structure according to the invention provides very efficient solution to scale up the testing capacity, and wherein the damaged part of the testing facility can be quickly and easily replaced to continue the testing operation. This ensures that the testing capacity stays even despite the environment wherein the accidents like the explosions and fires may regularly occur. Furthermore, the solution of the invention provides safer structure since the explosion and/or the fire is limited inside the test chamber that is inside the container meaning that there is a kind of double protection. Hence, the environment around the test facility is better protected.

Referring now to Figure 2, in an embodiment, the container comprises a first end 102_E1 that is open and the first internal space IS1 extends inside the container 102 from the first open end 102_E1 to form the cavity C. The container may comprise at least a floor, a roof, two side walls and one end wall. Hence, the structure is open from one end to form a tubular structure like the cavity that extend from the open end toward a second end that may be closed by the end wall. The open end may refer that the end wall is totally missing from the container opening the structure such that first internal space is in a direct connection with an exterior space of the container. The container may not comprise a door or a hatch to close the open end. Then there are no needs to open the door or hatch when inserting the test chamber into the cavity.

In an embodiment, the replaceable test chamber 104 is inserted into the cavity C and/or removed from the cavity C through the open first end of the container 102_E1. The test chamber, when inserted inside the cavity, may substantially fill the first internal space. In other words, the test chamber is dimension such that it fits inside the cavity and furthermore substantially fills the first internal space (cavity). There may be some clearances between outer surfaces of the test chamber and internal surfaces of the first internal space to enable easier inserting and/or removal of the test chamber.

Referring now to Figure 4, in an embodiment, the test chamber 104 comprises a first and a second end 104_E1, 104_E2, a floor, a roof and two side walls that form the test space inside the chamber. When the test chamber is installed inside the cavity the roof, the floor, the side walls and the second end wall is substantially inside the cavity. The first end 104_E1 may stay at the level of the open end of the container 102_E1 such that the first end of the test chamber 104_E1 closes the open end of the container 102_E1 as illustrated in Figure 1B. In other words, the first end of the test chamber is configured to close the open first end of the container when the test chamber is inserted into the container. The first end of the test chamber then forms the first end of the test chamber closing the structure of the container. The first end of the container may not comprise a door since the test chamber blocks the end.

Referring now to Figures 1A and 4, in an embodiment, the first end of the test chamber 104_E1 comprises a flange 106 extending perpendicularly from the longitudinal direction (center line) of the test chamber L and away from the test chamber 104. Hence the flange is a protrusion that extend away from the outer surface of the test chamber at the first end forming a collar around the first end of the test chamber. The flange is configured to be in connection with the first end of the container when the test chamber is inside the cavity. As described above, the first end of the test chamber is substantially at the same level with the first end of the container in the installed state, hence the flange is also nearby the first end of the container. The flange may be dimensioned such that it does not fit inside the cavity and stays outside of the cavity in the installed state of the test chamber. The flange may be pressed against the first end of the container when the test chamber is installed in the cavity. The flange may also limit how deep the test chamber can go into the cavity.

In an embodiment, the flange 106 may comprise one or more attaching members 108 to removably couple the test chamber with the container. Hence, the test chamber may only be coupled with the container from the first end that stays nearby the first end of the container, this enables easy coupling/decoupling of the test chamber since the first end stays mainly visible when the test chamber is in the cavity.

In an embodiment, the attaching member comprise a bolt joint. In an embodiment, the front end of the container and/or the flange may comprise holes for receiving the bolt that is tightened by a nut. In another embodiment, the hole(s) in the flange and/or first end of the container may comprise a thread and then the nut(s) are not needed. The bolt may be a separate component and/or may be integrated within the flange and/or within the front end of the container.

In another embodiment, the attaching member comprises a locking lever latch kind of mechanism or an equivalent quick clamping mechanism for removably coupling the test chamber with the container.

In an embodiment, the flange further comprises one or more alignment members to ensure right positioning of the test chamber into the cavity. The right positioning is essential that the attaching elements can be coupled.

Referring to Figures 1A and 1B, in an embodiment, the first end of the test chamber 104_E1 comprises a door 110 to enable access into the test chamber 104. The door or doors may be coupled with the flange, for example. Hence, the structure of the test arrangement may comprise the transportable container having replaceable test chamber inside, wherein the first end of the test chamber closes the first end of the container, and wherein the first end of the test chamber comprises the door(s) to enable access into the test chamber (the test space) from outside of the container. Hence, there may be a direct access into the test space of the test chamber from the outside of the container. The first end of the test chamber may comprise, for example, a double door covering substantially the whole first end. Hence, when the door is open, the whole first end of the test chamber is open to enable access of the large components inside for testing. The large components may be lifted by a lifting apparatus like a forklift, for example. When the door(s) is closed it also closes the first end of the test chamber, and the door(s) is configured to withstand the explosion or fire. The door(s) may be damaged in the explosion and/ or fire, and when the door(s) is in the test chamber, it is automatically replaced when replacing the test chamber.

In an embodiment, the test space inside the test chamber is isolated from an internal space of the container. Hence, for example the first internal space may not be in a direct connection with the test space. The test space inside the test chamber is the own isolated space. Then the first internal space that forms the cavity does not need to be so strong, in other words, it is not necessarily configured to withstand with the explosion and/or fire and hence the standard freight container can be used. Still, as the container surrounds the test chamber, it also provides some extra protection for the exterior of the container in the case of the explosion, for example.

In an embodiment, the test space inside the test chamber is gas tight. In another embodiment, the test space inside the test chamber is a fireproof and/or a splinter-proof. When the test chamber is the fire- and splinter-proof, it can withstand the explosion of the component(s) to be tested. When the test chamber is gas tight, it keeps the gases that may be released from the explosion of the component inside the test chamber. For example, the explosion of the battery may release toxic gases.

Referring to Figure 4, in an embodiment, the test chamber 104 comprises at least two lifting lugs 112A - D configured to be coupled with a lifting device and are arranged apart from each other in the longitudinal direction of the container L to enable gradual removal and/or coupling of the lifting device from the test chamber 104. In an embodiment the test chamber comprises a first pair of the lifting lugs 112A - B and a second pair of the lifting lugs 112C - D as illustrated in Figure 4. The fist pair is arranged nearby the first end of the test chamber and the second pair is arranged near by the second end of the test chamber. Nearby the first and/or the second end shall be understood broadly. For example, the first pair of the lugs may be arranged on a first half of the test chamber (from the first end towards the second end), and the second pair on a second half of the test chamber (from the second end towards the first end). The term "gradual removal and/or coupling" means that when the test chamber is inserted or removed, one of the first or the second pair is first removed or coupled with the lifting device. In the case of the inserting, the second end of the test chamber is inserted a little inside the cavity such that the second pair of the lifting lugs are still outside of the cavity, and then the second pair is removed from the lifting device. The first pair is still coupled with the lifting device and can be used to insert the test chamber deeper into the cavity. When then first pair is in the vicinity of the first end of the container, the first pair is removed. In some case, the test chamber, after removing the first pair of the lifting lugs, may be pushed inside the cavity by a forklift, for example.

In an embodiment, the first end of the test chamber comprises one or more features for a fork of the forklift. In other words, the first end may comprise features that are configured to receive the fork when pushing the test chamber inside the cavity. The feature may comprise a cavity, for example.

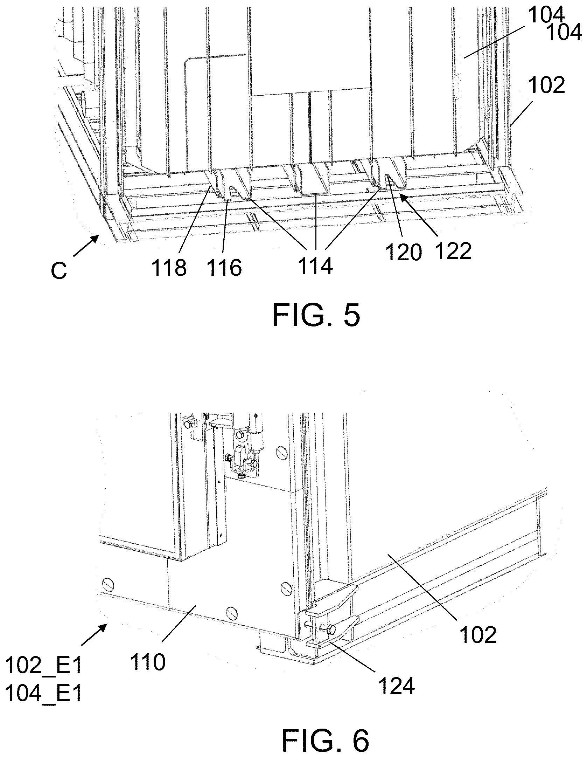

Referring to Figure 5, in an embodiment, the test chamber 104 and/or the cavity C comprise one or more guiding members 114 to guide insertion and/or removal of the test chamber 104 into or from the cavity C. The guiding member guides the test chamber when it is moving into or from the cavity, in other words, when the test chamber is inserted inside the cavity or removed from the cavity. The guiding member is configured to ensure proper positioning of the test chamber in the cavity. The proper positioning inside the cavity is very essential that all the interfaces can be connected to the test chamber. For example, the attaching members may be connected only when the test chamber is correctly positioned in relation to the container. The guiding member also reduces a risk of damages during the insertion or removal of the test chamber since the guiding member prevents crashing of the test chamber to the inner surfaces of the cavity when inserting or removing.

Referring still to Figure 5, in an embodiment, the one or more guiding members 114 comprise within the test chamber 104 at least one guide rail 116 and within the cavity C at least one guide groove 118 , wherein the guide rail 116 and groove 118 extend in the longitudinal direction of the container L, and wherein the guide groove 118 is configured to receive the guide rail 116 such that when the test chamber 104 is inserted or removed, the guide rail 116 moves inside the guide groove 118. The guide rail may extend from the vicinity of the first end of the test chamber to the vicinity of the second end of the test chamber, in other words, it may cover substantially the whole length of the bottom (floor) of the test chamber. The guide groove may cover substantially the whole length of the floor of the cavity, in other words, the length of the cavity in the longitudinal direction. The guide rail may be U- or C-profile (cross section) that is arranged on outer surface of the floor of the test chamber such that an open side is towards the test chamber and a closed side is away from the floor. Then, if the test chamber is placed on the ground, the closed side of the guide rail will be towards the ground. The guide groove may also be the U/C-profile that is arranged on the floor of the cavity (inside the cavity) such that the open side is upwards, in other words is towards the roof of the cavity. The profile in the cavity (guide groove) is dimensioned to receive the profile of the test chamber (guide rail), in other words, the profile in the test chamber goes inside the profile of the cavity through the open side of the profile as illustrated in Figure 5. The guide rail, inside the guide groove, can move substantially only in the longitudinal direction of the container. Then the guide groove may substantially block the movement of the test chamber in a width direction W. This enables desired positioning of the test chamber in relation to the container.

Referring still to Figure 5, in an embodiment, one or more guiding members 114 comprise one or more guide pins 120 and one or more tapered guide slots 122 configured to receive the guide pin 120 to guide insertion of the test chamber 104 into the cavity C. In an embodiment, the one or more guide pins 120 are arranged within the guide groove 118 and the one or more guide slots 122 are arranged within the guide rail 116. For example, the guide rail may comprise the tapered slot and the guide groove may comprise the pin such that when the guide rail is moved inside the guide groove, the pin can enter the slot as illustrated in Figure 5. When the pin enters the taper slot, the tapering forces the pin (and test chamber) to the right position in the width direction. As described above, the guide rail is configured to move inside the guide groove in the longitudinal direction. Anyway, there may be some clearance between the rail and groove to enable fluent movement that make possible the slight sideways movement in the width direction of the container. The pin and the tapered slot are configured to eliminate effect of this clearance for the positioning. The slot may be arranged within end of the guide rail that is nearby the second end of the test chamber, and the pin may be arranged within the end of the guide groove that is opposite to the end which stays nearby the second end of the container (open side of the first inner space). Then pin and the slot are capable of positioning the second end of the test chamber in the width direction.

Referring now to Figure 6, in an embodiment, the arrangement 100 further comprises one or more positioning members 124 arranged within the first end of the test chamber 104_E1 and/or the container 102_E1 to enable adjusting of a position of the first end of the test chamber 104_E1 in relation to the container 102. The positioning member may comprise an adjusting bolt configured to adjust the position of the first end of the test chamber in relation to the container. As described above, the pin and the tapered slot are configured to position the second end of the test chamber in relation to the container, and with the adjusting bolt, also the first end can be set to the right position. The adjusting bolt may move in the width direction of the container when rotated. It may further comprise a frame that is coupled with the container and is stationary. The frame may comprise a thread hole for the bolt such that the bolt can be rotated and move in relation to the frame and the container. A tip of the bolt may be configured to contact the first end of the test chamber such that it can move the first end of the test chamber in the width direction when rotated. The adjusting bolt may be arranged on both sides of the first end of the container making possible to move the first end of the test chamber in two directions. The first adjusting bolt may used to move the end to the right, and the second adjusting bolt may be used to move the end to the left, for example. The adjusting bolt may be arranged nearby the floor level of the container, for example.

In an embodiment, the guide rail 116 and/or the guide groove 118 comprise a low friction element arranged between them to reduce friction when the guide rail 116 moves inside the guide groove 118. The low friction element is configured to reduce friction between the test cavity and the test chamber when the test chamber is inserted inside the cavity. So, it may be arranged between the surfaces of the rail and groove that are configured to be against each other when the rail is in the groove. The low friction element may comprise a material that has a lower friction coefficient than metal. The low friction element may comprise plastic like Teflon (Polytetrafluoroethylene), for example. The low friction element may also be arranged between the side wall(s) and/or the roof(s) of the test chamber and container.

In an embodiment, the test arrangement further comprises one or more dampening members configured to dampen the collision of the first end of the test chamber against the first end of the container. The dampening member may be arranged within the first end of the container and/or the test chamber, for example. The dampening member may comprise a spring and/or some elastic material like rubber, for example. In an embodiment, the guiding element comprises the dampening element.

In an embodiment, the test chamber 104 comprises a heating element 126 arranged outside of the test chamber 104 to heat the test space inside the test chamber 104. The heating element may comprise a heating cable arranged on the outer surface(s) of the test chamber. The heating element may be arranged on the outer surface of the floor of the test chamber (bottom surface). The heating cable may be attached by a tape, like an aluminium tape. The heating cable may also be covered by metal sheets such that the heating cable is between the outers surface of the floor of the test chamber and the metal sheets. Then the heating cable is not exposed to the damages during the insertion of the test chamber, for example. The heating is essential to keep a temperature of the test space at the desired range. The heating also enables quick drying of the test space for example if the test space is washed. For example, the test space inside the test chamber may get dirty due to the testing and washing may be needed.

In an embodiment, the test chamber further comprises a system to cool down the test space. For example, the components to be tested may heat up in testing and the test space shall be cooled down. The cooling may be implemented the same way as the heating, but instead of the heating cable, pipes may be used to recirculate a thermal substance, for example. The thermal substance may comprise a coolant to transmit heat away from the test space. In an embodiment, a thermal substance recirculated in the pipes is configured to heat the test space. Hence, the same system may be used for heating or cooling the test space.

Referring now to Figures 3A and 3B, in an embodiment, the container 102 further comprises a second internal space IS2 separated from the first internal space IS1 by a first wall 128 to receive at last a part of test control equipment. Hence, the internal space of the container 102 is divided to the first internal space IS1 that is, at least partly open, to form the cavity, and also the second internal space IS2 for the test control equipment. The first and the second internal spaces IS1, IS2 may be separated from each other by the partition wall 128. As described above, the first inter space may extend inside the cavity from the first end of the container, and then the second internal space may extend inside the container from the second end of the container. In other words, the container may be divided into the first and the second internal space in the longitudinal direction of the container by the first wall. The second end of the container may comprise a door to enable access into the second internal space where the controlling equipment may be placed. The test controlling equipment refers to the equipment that are used for controlling the test equipment. The container may also comprise more than two separate internal spaces. For example, in some embodiment, there may be the first internal space forming a first cavity extending inside the container from the first end, and a second internal space forming a second cavity extending inside the container from the second end of the container, wherein the first cavity is configured to receive a first test chamber and the second cavity is configured to receive a second test chamber. Hence, the container may comprise at least two replaceable test chambers at both ends. In an embodiment, the container further comprises the third internal space inside the container that is arranged between the first and the second cavities. The third internal space is configured to receive the controlling equipment, for example. The side wall of the container may comprise a door for enabling access into the third internal space.

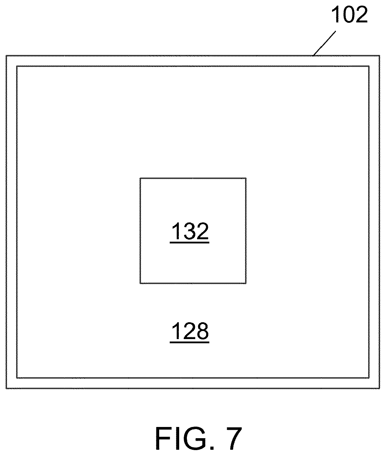

Referring now to Figures 4 and 7, in an embodiment the test chamber 104 comprises a first lead-in interface 130 within the second end 104_E2 and the first wall comprises a second lead-in interface 132, wherein the first and the second interfaces 130, 132 are configured to be aligned when the test chamber 104 is inserted inside the cavity C such that the test control equipment in the second internal space IS2 can be connected with the test equipment and/or the component to be tested inside the test space TS through the first and the second lead-in interfaces 130, 132. The lead-in interface may refer to the sealing interface. Aligning means that the first and the second lead-in interfaces are nearby when the test chamber is inserted into the cavity and, for example, cables from the second internal space can be routed through the second lead-in interface into the cavity and through the second lead-in interface into the test chamber. The aligning may be enabled by the guiding means of the test chamber, for example. The lead-in interface may comprise sealing elements like a rubber sealing that is configured to be pressed around the cable. The lead-in interface may comprise a plurality of lead-ins. For example, each cable may have own lead-in though the lead-in interface. For example, both lead-in interfaces may comprise a first, a second and a third lead-in and all the lead-ins are configured to be aligned when the cavity is in the chamber. For example, the first lead-in of the first lead-in interface is aligned with the first lead-in of the second lead-in interface. In other words, centre points of the first lead-ins in both interfaces are aligned such that cable can directly go though the first and the second lead-in of both interfaces. Then there is no need to bend the cable. In an embodiment, there is an air gap between the first and the second lead-in interfaces. The operator may be in the second internal space of the container during testing, and in the case of the explosion, the double lead-in interface (with the airgap) protects the operator. So, two lead-in interfaces give better protection for the second internal space in which the control equipment may be placed.

Referring to Figure 4, in an embodiment, the transportable test arrangement further comprises a ventilation system 134 that is connected with the test space TS of the test chamber 104. For example, in the case of explosion or fire, the released gases may be removed and also filtered by the ventilation system. The ventilation system may be, at least partly, on the roof of the test chamber. The ventilation system is configured to withstand with the explosion and/or fire, for example. The ventilation system may be coupled with the test chamber after the test chamber is installed inside the cavity. The test chamber may comprise an interface for coupling the ventilation system.

The concept of the invention provides very effective system for testing the sensitive electric components that may even explode during the test. The replaceable test chamber is easy to change in the case of the explosion in which the test chamber may be damaged. The possible damages are limited inside the test space of the chamber, so the container may be then used with another replaceable test chamber. This provide may benefits since the container may comprise a lot of expensive testing infra like test control equipment etc. The concept provide also monetary benefit since the replaceable test chamber is remarkably cheaper than the whole container, the test chamber is logistically also much easier to move between different locations than the whole container.

Even though the invention has been described above with reference to an example according to the accompanying drawings, it is clear that the invention is not restricted thereto but can be modified in several ways within the scope of the appended claims. Therefore, all words and expressions should be interpreted broadly, and they are intended to illustrate, not to restrict, the embodiment. It will be obvious to a person skilled in the art that, as technology advances, the inventive concept can be implemented in various ways. Further, it is clear to a person skilled in the art that the described embodiments may, but are not required to, be combined with other embodiments in various ways.

## Claims

1. A transportable test arrangement (100) comprising:
a transportable container (102) having at least a first internal space (IS1), wherein one side of the first internal space (IS1) is open to form a cavity (C) inside the transportable container (102); and
a replaceable test chamber (104) forming a test space (TS) for receiving one or more components to be tested and/or test equipment,
wherein the cavity (C) in the transportable container (102) is configured to receive the replaceable test chamber (104) via the open side of the first internal space (IS1) such that the test chamber (104) goes substantially inside the container, and wherein the replaceable test chamber (104) is removably coupled with the transportable container (102).

2. The arrangement (100) of claim 1, wherein the open side of the first internal space (IS1) is a first end of the container (102_E1), and the first internal space (IS1) extends from the first open end (102_E1) towards a second end of the container (102_E2).

3. The arrangement (100) of any preceding claim, wherein a first end of the test chamber (104_E1) is configured to stay at least partly outside of the cavity (C) and to close the first open end of the container (102_E1) when the test chamber (104) is inserted into the cavity (C).

4. The arrangement of claim 3, wherein the first end of the test chamber (104_E1) comprises a flange (106) configured to be in connection with the first end of the container (102_E1) when the test chamber (104) is inserted into the cavity (C) and wherein the flange (106) comprises one or more attaching members (108) to removably couple the test chamber (104) with the container (102).

5. The arrangement (100) of claim 3-4, wherein the first end of the test chamber (104_E1) comprises at least one door (110) to enable access into the test space (TS) from outside of the container (102).

6. The arrangement (100) of any preceding claim, wherein the test chamber (104) comprises at least two lifting lugs (112) configured to be coupled with a lifting device and are arranged apart from each other in a longitudinal direction of the container (L) to enable gradual removal of the lifting device from the test chamber (104).

7. The arrangement (100) of any preceding claim, wherein the test chamber (104) and/or the cavity (C) comprise one or more guiding members (114) to guide insertion and/or removal of the test chamber (104) into or from the cavity (C).

8. The arrangement (100) of claim 7, wherein the one or more guiding members (114) comprise within the test chamber at least one guide rail (116) and within the cavity at least one guide groove (118) , wherein the guide rail (116) and groove (118) extend in the longitudinal direction of the container (L), and wherein the guide groove (118) is configured to receive the guide rail (116) such that when the test chamber (104) is inserted or removed, the guide rail (116) moves inside the guide groove (118).

9. The arrangement (100) of claim 8, wherein the guide rail (116) and/or the guide groove (118) comprise a low friction element arranged between them to reduce friction when the guide rail (116) moves inside the guide groove (118).

10. The arrangement (100) of claims 7 - 9, wherein one or more guiding members (114) comprise one or more guide pins (120) and one or more tapered guide slots (122) configured to receive the guide pin (120) to guide insertion of the test chamber (104) into the cavity (C).

11. The arrangement (100) of claim 10, wherein the one or more guide pins (120) are arranged within the guide groove (118) and the one or more guide slots (122) are arranged within the guide rail (116).

12. The arrangement (100) of any preceding claim, wherein the arrangement (100) further comprises one or more positioning members (124) arranged within the first end of the test chamber (104_E1) and/or the container (102_E1) to enable adjusting of a position of the first end of the test chamber (104_E1) in relation to the container (102).

13. The arrangement (100) of any preceding claim, wherein the test chamber (104) comprises a heating element (126) arranged outside of the test chamber (104) to heat the test space (TS).

14. The arrangement (100) of any preceding claims, wherein the container (102) further comprises a second internal space (IS2) separated from the first internal space by a first wall (128) to receive at last a part of test control equipment.

15. The arrangement (100) of claim 14, wherein the test chamber (104) comprises a first lead-in interface (130) on a second end (104_E2) and the first wall comprises a second lead-in interface (132), wherein the first and the second interfaces (130, 132) are configured to be aligned when the test chamber (104) is inserted inside the cavity (C) such that the test control equipment in the second internal space (IS2) can be connected with the test equipment and/or the component to be tested inside the test space (TS) through the first and the second lead-in interfaces (130, 132).
